# EUROPÄISCHE PATENTSCHRIFT

(11) **EP 1 221 726 B1**
(45) Veröffentlichungstag und Bekanntmachung des Hinweises auf die Patenterteilung: **17.10.2007**
(21) Anmeldenummer: 01129506.0
(22) Anmeldetag: 11.12.2001
(51) Int. Cl.: H05K 1/02

(54) **Träger für Bauelemente der Mikrosystemtechnik**
Carrier for components of microsystems
Support pour composants de microsystèmes

(30) Priorität: 09.01.2001 DE 10100679
(43) Veröffentlichungstag der Anmeldung: 10.07.2002
(73) Patentinhaber: ABB RESEARCH LTD., 8050 Zürich (CH)
(72) Erfinder: Binz, Dieter, Dr., 69493 Hirschberg (DE); Vogel, Albrecht, Dr., 76297 Stutensee (DE); Krippner, Peter, Dr., 76199 Karlsruhe (DE)
(74) Vertreter: Miller, Toivo

(56) Entgegenhaltungen:
- EP-A- 0 915 515
- US-A- 3 662 150

## Beschreibung

Die Erfindung betrifft ein Trägerelement für Bauelemente der Mikrosystemtechnik gemäß dem Oberbegriff des Patentanspruchs 1.

Solche Trägerelemente finden vor allem dort eine Anwendung, wo eine Vielzahl von Bauelementen mit sehr kleinen Abmessungen zu einer Baueinheit zusammen gefasst werden, und auf definierten Temperaturniveaus zu halten sind.

Die bis jetzt bekannten Trägerelemente weisen Platten auf, die gegebenenfalls mit Ausnehmungen versehen sind. Die Bauelemente werden auf den Oberflächen der Platten oder in diesen Ausnehmungen angeordnet. Durch die kleinen Abmessungen der Platten und die damit verbundene räumliche Enge auf den Oberflächen der Platten und in deren Ausnehmungen gestaltet sich die Isolierung der einzelnen Bauelemente gegeneinander schwierig. Für die Temperierung muß deshalb ein wesentlich erhöhter Energiebedarf in Kauf genommen werden. Zudem geht Wärme an die Umgebung der Trägerelemente verloren. Eine zu warme Umgebung der Trägerelemente beeinflußt zudem Prozesse, für deren Durchführung eine Kühlung der Bauelemente erforderlich ist.

Der Erfindung liegt die Aufgabe zugrunde, ein Trägerelement für Bauelemente der Mikrosystemtechnik aufzuzeigen, mit dem eine Vielzahl von Bauelementen dauerhaft auf vorgegebenen Temperaturen gehalten werden können.

Diese Aufgabe wird durch die Merkmale des Patentanspruchs 1 gelöst.

Durch die erfindungsgemäße Ausbildung des Trägerelements ist es möglich, Bauelemente, die auf der Platte des Trägerelements oder in deren Ausnehmungen angeordnet sind, dauerhaft zu kühlen oder zu heizen, ohne dass eine gegenseitige Beeinflussung der Bauelemente erfolgt. Vor allem wird die Kühlung der Bauelemente mit Hilfe von Peltierelementen verbessert. Gleichzeitig wird die aufzuwendende Energie reduziert, die zum Heizen und Kühlen erforderlich ist, was insbesondere für transportable, Batterie betriebene Geräte vorteilhaft ist.

Weitere erfinderische Merkmale sind in den abhängigen Ansprüchen gekennzeichnet.

Die Erfindung wird nachfolgend an Hand von schematischen Zeichnungen näher erläutert.

Es zeigen:
Fig. 1 ein Trägerelement zur Aufnahme von Bauelementen der Mikrosystemtechnik,
Fig. 2 eine Variante des in Fig. 1 dargestellten Trägerelements,
Fig. 3 eine vereinfachte Ausführungsform des in Fig. 1 dargestellten Trägerelements,
Fig. 4 eine Variante des in Fig. 1 dargestellten Trägerelements,
Fig. 5 ein Trägerelement mit unterteilter Platte.

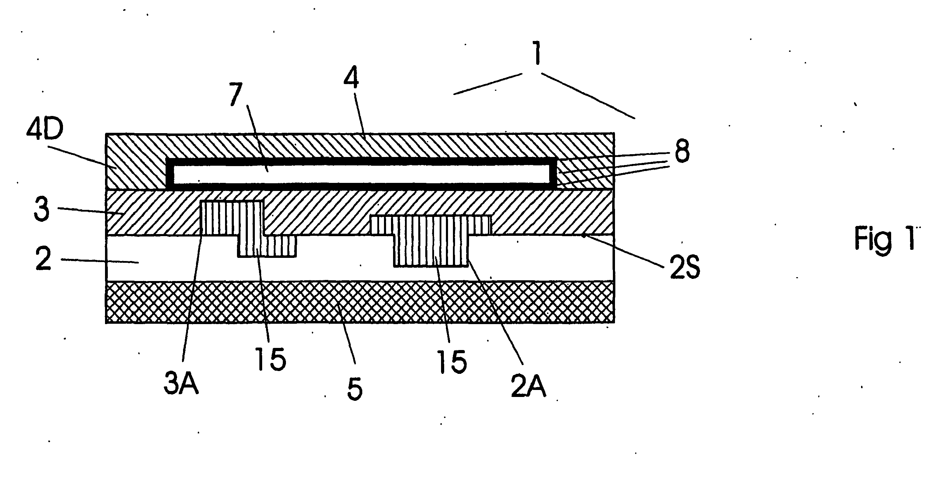

Das in Fig. 1 dargestellte Trägerelement 1 wird im wesentlichen durch eine Platte 2, einen Deckel 3, eine Abdeckung 4 und ein Bauteil 5 gebildet. Bei dem Bauteil 5 handelt es sich um ein Temperiermodul, das entweder als Peltierelement oder als Heizblock ausgebildet ist. Die Platte 2 ist aus Silizium oder Glas gefertigt. In der Oberfläche 2S der Platte 2 sind Ausnehmungen 2A ausgebildet, die für die Aufnahme von Bauelementen 15 vorgesehen sind, die in der Mikrosystemtechnik zur Anwendung kommen. Es ist jedoch auch möglich, Bauelement 15 auf der Oberfläche 2S des Trägerelements 1 anzuordnen. Mit dem flächig ausgebildeten Deckel 3 werden die Bauelemente 15 nach außen abgeschirmt. Der Deckel 3 ist ebenso groß wie die Oberfläche der Platte 2. Er ist auf diese aufgelegt und gasdicht damit verbunden. An den Stellen, an denen Bauelemente 15 unmittelbar auf der Oberfläche 2S der Platte 2 angeordnet sind, ist der Deckel 3 ebenfalls mit Ausnehmungen 3A versehen, in welche die Bauelemente 15 hinein ragen. Der Deckel 3 ist aus Glas oder Silizium gefertigt. Damit die Bauelemente 15 voll funktionsfähig sind, müssen sie zum Teil gekühlt oder beheizt werden. Um Wärmeverluste zu vermeiden, oder die Einwirkung von Wärme aus der Umgebung auf gekühlte Bauelemente 15 zu verhindern, sind Maßnahmen zur Isolation vorgesehen. Hierfür ist der Deckel 3 erfindungsgemäß mit einer Abdeckung 4 versehen, deren Größe an die Größe des Deckels 3 angepasst ist. Die Abdeckung 4 ist aus Silizium oder Glas gefertigt. Die Abdeckung 4 ist rundum mit einem dem Dekkel 3 zugewandten Rand 4D versehen. Mit diesem ist sie auf den Rand des Deckel 4 aufgesetzt und gasdicht mit dem Deckel 4 verbunden. Durch den Rand 4D wird zwischen dem Deckel 3 und der Abdeckung 4 ein Hohlraum 7 geschaffen, der evakuiert ist. Die den Hohlraum 7 nach innen begrenzenden Flächen sind mit einer spiegelnden metallischen Beschichtung 8 überzogen, die vorzugsweise aus Au, Ag oder Al besteht.

Um die Bauelemente 15 heizen und/oder kühlen zu können, ist die Unterseite der Platte 2 thermisch gut leitend mit dem Temperiermodul 5 verbunden. Er hat bei dem hier dargestellten Ausführungsbeispiel die gleiche Größe wie die Platte 2. Bei Bedarf kann er auch kleiner ausgebildet werden, so dass er an der Unterseite der Platte 2 unmittelbar unterhalb eines Bauelements 15 angeordnet werden kann (hier nicht dargestellt). Müssen die Bauelemente 15 nur geheizt werden, so wird ein Temperiermodul 5 verwendet, das als Heizblock ausgebildet ist.

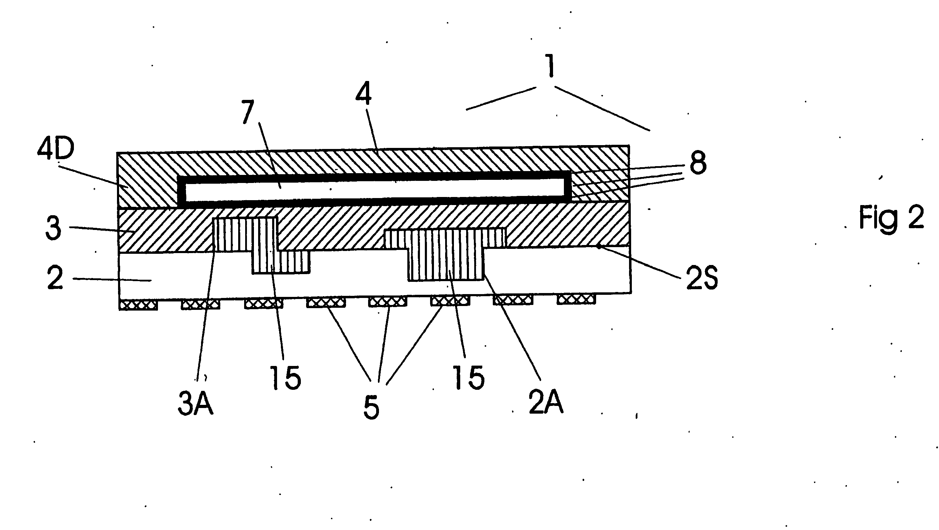

Das in Fig. 2 dargestellte Trägerelement 1 unterscheidet sich von dem in Fig. 1 gezeigten und in der zugehörigen Beschreibung erläuterten Trägerelement 1 lediglich in der Ausführung des Bauteils 5. Gleiche Bauteile sind deshalb mit den gleichen Bezugszeichen versehen. Unter der Platte 2 ist außen nur das als Heizwendel ausgebildet Bauteil 5 angeordnet. Eine solche Heizwendel 5 reicht aus, wenn die Bauelemente 15 nur auf einer Temperatur zu halten sind, die über der Umgebungstemperatur liegt. Die Heizwendel 5 kann durch eine nur wenige Mikrometer dicke Beschichtung auf der Unterseite der Platte 2 gebildet werden. Es kann sich dabei um eine in Siebdrucktechnik aufgebrachte Leiterbahnstruktur handeln, die als Widerstandsheizung dient.

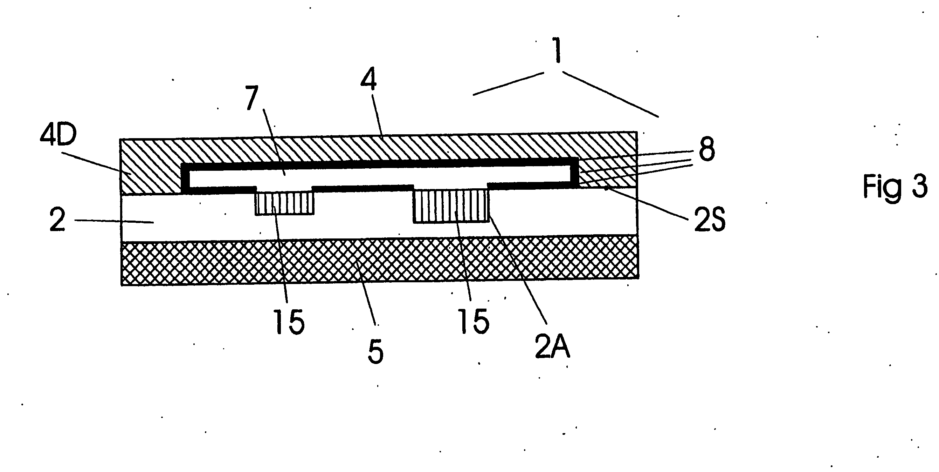

Fig 3 zeigt eine vereinfachte Ausführungsform des in Fig.1 dargestellten Trägerelements 1. Dieses Trägerelement 1 ist nur mit einer Platte 2, einer die Funktion des Deckels übernehmenden Abdeckung 4 und einem Temperiermodul 5 versehen. Diese Ausführungsform eines Trägerelements 1 kann dann verwendet werden, wenn Bauelemente 15 zum Einsatz kommen, die auch dann voll funktionsfähig sind, wenn sie in einem evakuierten Raum angeordnet sind. Die Bauelemente 15 sind hierbei in Ausnehmungen 2A der Platte 2 angeordnet. Die Abdeckung 4 dient hierbei gleichzeitig als Deckel, so dass auf einen solchen verzichtet werden kann. Die Abdeckung 4 hat die gleiche Größe wie die Oberfläche 2S der Platte 2. Sie ist in gleicher Weise wie die in Fig 1 dargestellte und in der zugehörigen Beschreibung erläuterte Abdeckung 4 ausgebildet. Die Abdeckung 4 ist mit ihrem Rand 4D auf dem Rand der Platte 2 abgestützt und gasdicht mit der Platte 2 verbunden. Der Hohlraum 7 zwischen der Platte 2 und der Abdeckung 4 ist evakuiert. Die Innenflächen der Abdeckung 4 sowie die Bereiche der Oberfläche 2S der Platte 2, die keine Ausnehmungen 2A aufweisen, sind mit einer spiegelnden metallischen Beschichtung 8 aus Au, Ag, Al überzogen, die hierbei auf die Innenflächen der Abdeckung 4 und die Oberfläche 2S der Platte 2 aufgedampft ist. Auf der Unterseite der Platte 2 ist ein Temperiermodul 5 angeordnet, der als Peltierelement oder als Heizblock ausgebildet ist. Zum Heizen der Bauelemente 15 reicht es aus, wenn auf der Unterseite der Platte 2 nur eine Heizwendel angeordnet wird, wie in Fig. 2 dargestellt und in der zugehörigen Beschreibung erläutert.

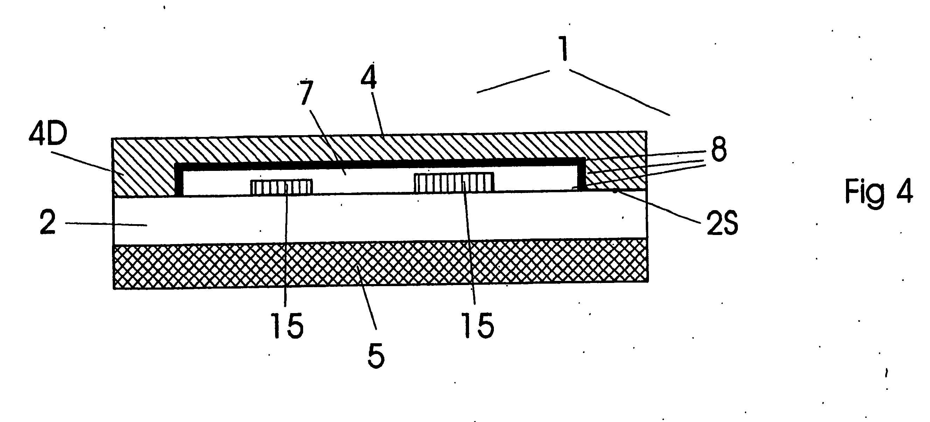

Fig 4 zeigt ein Trägerelement 1, das im wesentlichen baugleich mit dem in Fig. 3 dargestellten und in der zugehörigen Beschreibung erläuterten Trägerelement 1 ist. Gleich Bauelemente sind deshalb mit gleichen Bezugszeichen versehen. Diese Ausführungsform des Trägerelements 1 kann ebenfalls nur dann verwendet werden, wenn Bauelemente 15 zum Einsatz kommen, die auch dann voll funktionsfähig sind, wenn sie in einem evakuierten Raum angeordnet sind. Der Unterschied zwischen den Trägerelementen 1 gemäß der Figuren 3 und besteht darin, dass die Bauelemente 15 hierbei auf der Oberfläche der Platte 2 angeordnet sind. Die Abdeckung 4 übernimmt auch hierbei die Funktion des Deckels, so dass auf einen solchen hierbei verzichtet werden kann. Der Abstand zwischen der Platte 2 und der Abdeckung 4 ist so groß, dass für die Bauelemente 15 ausreichend Platz in dem Hohlraum 7 verbleibt. Die Innenflächen der Abdeckung 4 sind mit einer spiegelnden metallischen Beschichtung 8 aus Au, Ag, Al überzogen. Auf der Unterseite der Platte 2 ist ein als Peltierelement oder ein als Heizblock ausgebildeter Temperiermodul 5 angeordnet. Als Heizung für die Bauelemente 15 kann es ausreichen, wenn auf der Unterseite der Platte 2 nur eine Heizwendel 5 angeordnet wird, wie in Fig. 2 dargestellt und in der zugehörigen Beschreibung erläutert.

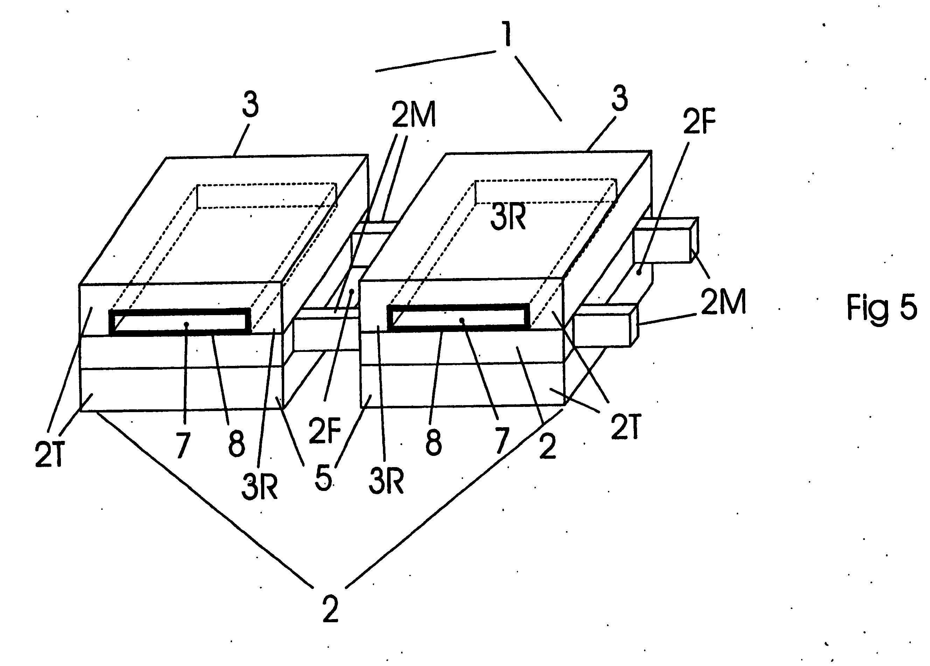

Fig. 5 zeigt ein Trägerelement 1, bei dem die Platte 2 in mehrere Bereiche 2T unterteilt ist. Hierfür sind in definierten Abständen Fugen 2F senkrecht zur Längsachse der Platte 2 ausgebildet. Die Platte 2 ist nicht vollständig durchtrennt, vielmehr sind in jeder Fuge 2F wenigstens zwei Stege 2M ausgebildet, die parallel zur Längsachse der Platte 2 ausgerichtet sind, und einen vorgegebenen Abstand voneinander haben. Die Breite der Stege 2M ist so bemessen, dass die Tragfähigkeit des Trägerelements 1 erhalten bleibt. Es muß hierbei sichergestellt werden, dass in den Bereichen 2T keine Ausnehmungen in der unmittelbaren Nähe der Stege 2M ausgebildet werden. Die Platte 2 weist damit Bereiche 2T auf, die thermisch gegeneinander isoliert sind, so dass in einem Bereich 2T zu kühlende Bauelemente (hier nicht dargestellt) und in dem unmittelbar angrenzenden Bereich 2T Bauelemente (hier nicht dargestellt) angeordnet werden können, die geheizt werden müssen, ohne dass eine gegenseitige Beeinflussung erfolgt. Die Bauelemente (hier nicht dargestellt) werden in Ausnehmungen (hier nicht dargestellt) angeordnet, die in den Oberflächen der Bereiche 2T ausgebildet sind. Außen auf der Unterseite der Bereiche 2T sind Temperiermodule 5 installiert. Der Deckel 3 ist mit Rändern 3R versehen, die auf den Bereichen 2T der Platte 2 abgestützt und gasdicht mit deren Oberflächen verbunden sind. Zwischen dem Deckel 3 und den Bereichen 2T sind ebenfalls Hohlräume 7 ausgebildet, welche durch die Ränder 3R des Deckels 3 mit begrenzt werden. Die Hohlräume 7 sind evakuiert. Auf ihren Innenflächen ist jeweils eine metallische spiegelende Beschichtung 8 aus Au, AG oder Al aufgetragen.

Es ist auch möglich, mehre einzelne Platten 2, welche die Größe der Bereiche 2T aufweisen, über Stege 2M in der gleichen Weise zu verbinden, wie oben beschreiben. Die Stege 2M werden in diesem Fall als einem tragfähigen und gleichzeitig thermisch isolierenden Material gefertigt, so dass die Wärmeleitfähigkeit zwischen den Bereichen 2T noch mehr herabgesetzt wird. Der übrige Teil des Trägerelements 1 wird in der gleichen Wiese ausgebildet wie oben beschreiben.

## Patentansprüche

1. Trägerelement mit wenigstens einer Platte (2) zur Aufnahme von Bauelementen (15) der Mikrosystemtechnik und einem Deckel (3), der die Bauelemente (15) nach außen abgeschirmt, **dadurch gekennzeichnet, dass** wenigstens eine die Platte (2) und den Deckel (3) bereichsweise nach innen und außen abschirmende thermische Isolierung (4, 5, 7, 8) vorgesehen ist.

2. Trägerelement nach Anspruch 1, **dadurch gekennzeichnet, dass** der Deckel (3) in vorgebbarem Abstand von einer zusätzlichen Abdeckung (4) umgeben und gasdicht damit verbunden damit ist, dass die Innenflächen des zwischen dem Deckel (3) und der Abdeckung (4) ausgebildeten und evakuierten Hohlraums (7) mit einer spiegelnden metallischen Beschichtung (8) versehen sind, und dass wenigstens auf der Unterseite der Platte (2) ein Bauteil (5) zum Heizen und/oder Kühlen vorgesehen ist.

3. Trägerelement nach einem der Ansprüche 1 oder 2, **dadurch gekennzeichnet, dass** der Deckel (3) im Abstand von einer zusätzlichen Abdeckung (4) umgeben und gasdicht damit verbunden ist, dass die Innenflächen des zwischen Deckel (3) und Abdeckung (4) ausgebildeten evakuierten Hohlraums (7) mit einer spiegelnden metallischen Beschichtung (8) aus Au, Ag oder Al versehen sind, und dass wenigstens auf der Unterseite der Platte (2) ein als Peltierelement und/oder Heizblock ausgebildeter Temperiermodul 5 angeordnet ist.

4. Trägerelement nach einem der Ansprüche 1 oder 2, **dadurch gekennzeichnet, dass** der Deckel (3) im Abstand von einer zusätzlichen Abdeckung (4) umgeben und gasdicht damit verbunden ist, dass die Innenflächen des zwischen Deckel (3) und Abdeckung (4) ausgebildeten, evakuierten Hohlraums (7) mit einer spiegelnden metallischen Beschichtung (8) aus Au, Ag oder Al versehen sind, und dass wenigstens auf der Unterseite der Platte (2) eine Heizwendel (5) angeordnet ist.

5. Trägerelement nach Anspruch 1 oder 2, **dadurch gekennzeichnet, dass** eine als Deckel dienende Abdeckung (4) mit einem der Platte (2) zugewandten Rand (4D) vorsehen ist, dass der Rand (4D) auf dem Rand der Platte (2) aufgesetzt und gasdicht damit verbunden ist, dass auf den Innenflächen des zwischen Platte (2) und Abdekkung (4) gebildeten und evakuierten Hohlraums (7) wenigstens eine spiegelnde metallische Beschichtung (8) aus Au, Ag oder Al aufgetragen ist, und dass wenigstens auf der Unterseite der Platte (2) ein als Peltierelement und/oder Heizblock ausgebildeter Temperiermodul (5) angeordnet ist.

6. Trägerelement nach Anspruch 1oder 2, **dadurch gekennzeichnet, dass** eine als Deckel dienende Abdeckung (4) mit einem der Platte (2) zugewandten Rand (4D) vorsehen ist, dass der Rand (4D) auf dem Rand der Platte (2) aufgesetzt und gasdicht damit verbunden ist, dass die Innenflächen des zwischen Platte (2) und Abdeckung (4) gebildeten und evakuierten Hohlraums (7) wenigstens im Bereich der Abdeckung (4) mit einer spiegelnden metallischen Beschichtung (8) vorzugsweise aus Au, Ag oder Al versehen sind, und dass wenigstens auf der Unterseite der Platte (2) ein als Peltierelement und/oder Heizblock ausgebildeter Temperiermodul (5) angeordnet ist.

7. Trägerelement nach einem der Ansprüche 1 bis 6, **dadurch gekennzeichnet, dass** jede Platte (2) in zwei oder mehrere Bereiche (2T) unterteilt ist, die nur noch über Stege (2M) miteinander verbunden sind.

8. Trägerelement nach einem der Ansprüche 1 bis 7, **dadurch gekennzeichnet, dass** jede Platte (2) zwei oder mehrere Bereiche (2T) aufweist, die über Stege (2M) aus einem tragfähigen, thermisch isolierenden Werkstoff miteinander verbunden sind.

## Claims

1. Support element having at least one plate (2) for receiving components (15) used in microsystems technology, and a cover (3) which shields the components (15) with respect to the outside, **characterized in that** at least one thermal insulation means (4, 5, 7, 8), which shields the plate (2) and the cover (3) with respect to the inside and the outside in certain regions, is provided.

2. Support element according to Claim 1, **characterized in that** the cover (3) is surrounded, at a predeterminable distance, by an additional covering (4) and is connected thereto in a gastight manner, **in that** the inner surfaces of the cavity (7) which is formed between the cover (3) and the covering (4) and is evacuated are provided with a reflective metallic coating (8), and **in that** a part (5) for heating and/or cooling is provided at least on the underside of the plate (2).

3. Support element according to one of Claims 1 or 2, **characterized in that** the cover (3) is surrounded, at a distance, by an additional covering (4) and is connected thereto in a gastight manner, **in that** the inner surfaces of the evacuated cavity (7) which is formed between cover (3) and covering (4) are provided with a reflective metallic coating (8) of Au, Ag or Al, and **in that** a temperature-control module (5), which is designed as a Peltier element and/or a heater block, is arranged at least on the underside of the plate (2).

4. Support element according to one of Claims 1 or 2, **characterized in that** the cover (3) is surrounded at a distance by an additional covering (4) and is connected thereto in a gastight manner, **in that** the inner surfaces of the evacuated cavity (7) formed between cover (3) and covering (4) are provided with a reflective metallic coating (8) of Au, Ag or Al, and **in that** a heater coil (5) is arranged at least on the underside of the plate (2).

5. Support element according to Claim 1 or 2, **characterized in that** a covering (4), which serves as the cover, is provided, having an edge (4D) which faces the plate (2), **in that** the edge (4D) is fitted on the edge of the plate (2) and is connected thereto in a gastight manner, **in that** at least one reflective metallic coating (8) of Au, Ag or Al is applied to the inner surfaces of the cavity (7) which is formed between plate (2) and covering (4) and is evacuated, and **in that** a temperature-control module (5), which is designed as a Peltier element and/or a heater block, is arranged at least on the underside of the plate (2).

6. Support element according to Claim 1 or 2, **characterized in that** a covering (4), which serves as the cover, is provided, having an edge (4D) which faces the plate (2), **in that** the edge (4D) is fitted on the edge of the plate (2) and is connected thereto in a gastight manner, **in that** the inner surfaces of the cavity (7) which is formed between plate (2) and covering (4) and is evacuated is provided, at least in the region of the covering (4), with a reflective metallic coating (8) preferably of Au, Ag or Al, and **in that** a temperature-control module (5), which is designed as a Peltier element and/or a heater block, is arranged at least on the underside of the plate (2).

7. Support element according to one of Claims 1 to 7, **characterized in that** each plate (2) is divided into two or more regions (2T) which are only connected to one another via webs (2M).

8. Support element according to one of Claims 1 to 8, **characterized in that** each plate (2) has two or more regions (2T) which are connected to one another via webs (2M) made from a load-bearing, thermally insulating material.

## Revendications

1. Élément de support avec au moins une plaque (2) destiné à recevoir des composants (15) de micro-systèmes et avec un couvercle (3) qui protège les composants (15) de l'extérieur, **caractérisé en ce qu'**il est prévu au moins une isolation thermique (4, 5, 7, 8) isolant par zones la plaque (2) et le couvercle (3) vers l'intérieur et l'extérieur.

2. Élément de support selon la revendication 1, **caractérisé en ce que** le couvercle (3) est entouré à une distance pouvant être prédéterminée par une couverture supplémentaire (4) et relié à celle-ci de manière étanche aux gaz, **en ce que** les surfaces intérieures de la cavité (7) formée entre le couvercle (3) et la couverture (4) et dans laquelle un vide est créé sont recouvertes d'un revêtement métallique réfléchissant (8), et **en ce qu'**il est prévu au moins sur la face inférieure de la plaque (2) un élément (5) pour le chauffage et/ou le refroidissement.

3. Élément de support selon l'une des revendications 1 ou 2, **caractérisé en ce que** le couvercle (3) est entouré à distance par une couverture supplémentaire (4) et relié à celle-ci de manière étanche aux gaz, **en ce que** les surfaces intérieures de la cavité (7) formée entre le couvercle (3) et la couverture (4) et dans laquelle un vide est créé sont recouvertes d'un revêtement métallique réfléchissant (8) en or, argent ou aluminium, et **en ce qu'**un module de régulation de la température (5) conçu comme un élément Peltier et/ou un bloc chauffant est disposé au moins sur la face inférieure de la plaque (2).

4. Élément de support selon l'une des revendications 1 ou 2, **caractérisé en ce que** le couvercle (3) est entouré à distance par une couverture supplémentaire (4) et relié à celle-ci de manière étanche aux gaz, **en ce que** les surfaces intérieures de la cavité (7) formée entre le couvercle (3) et la couverture (4) et dans laquelle un vide est créé sont recouvertes d'un revêtement métallique réfléchissant (8) en or, argent ou aluminium, et **en ce qu'**une spirale de chauffage (5) est disposée au moins sur la face inférieure de la plaque (2).

5. Élément de support selon la revendication 1 ou 2, **caractérisé en ce qu'**il est prévu une couverture (4) servant de couvercle avec un bord (4D) orienté vers la plaque (2), **en ce que** le bord (4D) est posé sur le bord de la plaque (2) et relié à celle-ci de manière étanche aux gaz, **en ce qu'**il est prévu appliqué sur les surfaces intérieures de la cavité (7) formée entre la plaque (2) et la couverture (4) et dans laquelle un vide est créé au moins un revêtement métallique réfléchissant (8) en or, argent ou aluminium, et **en ce qu'**un module de régulation de la température (5) conçu comme un élément Peltier et/ou un bloc chauffant est disposé au moins sur la face inférieure de la plaque (2).

6. Élément de support selon la revendication 1 ou 2, **caractérisé en ce qu'**il est prévu une couverture (4) servant de couvercle avec un bord (4D) orienté vers la plaque (2), **en ce que** le bord (4D) est posé sur le bord de la plaque (2) et relié à celle-ci de manière étanche aux gaz, **en ce qu'**il est prévu appliqué sur les surfaces intérieures de la cavité (7) formée entre la plaque (2) et la couverture (4) et dans laquelle un vide est créé, au moins au niveau de la couverture, un revêtement métallique réfléchissant (8), de préférence en or, argent ou aluminium, et **en ce qu'**un module de régulation de la température (5) conçu comme un élément Peltier et/ou un bloc chauffant est disposé au moins sur la face inférieure de la plaque (2).

7. Élément de support selon l'une des revendications 1 à 6, **caractérisé en ce que** chaque plaque (2) est divisée en deux ou plusieurs zones (2T) qui ne sont reliées entre elles que par des barrettes (2M).

8. Élément de support selon l'une des revendications 1 à 7, **caractérisé en ce que** chaque plaque (2) présente deux ou plusieurs zones (2T) qui sont reliées entre elles par des barrettes (2M) faites d'un matériau portant et isolant thermique.
